# EUROPEAN PATENT APPLICATION

(11) **EP 3 427 942 A1**
(43) Date of publication of application: **16.01.2019**
(21) Application number: 16893600.3
(22) Date of filing: 25.11.2016
(51) Int. Cl.: B32B 15/08, G02B 5/26

(54) **LIGHT-TRANSMITTING LAMINATE AND METHOD FOR PRODUCING LIGHT-TRANSMITTING LAMINATE**

(30) Priority: 08.03.2016 JP 2016044836; 30.09.2016 JP 2016193128
(71) Applicant: Sumitomo Riko Company Limited, Komaki-shi, Aichi 485-8550 (JP)
(72) Inventor: INUDUKA, Masataka, Komaki-shi Aichi 485-8550 (JP); SUZUKI, Yoshitake, Komaki-shi Aichi 485-8550 (JP); GOTO, Osamu, Komaki-shi Aichi 485-8550 (JP); TAKAO, Yuzo, Komaki-shi Aichi 485-8550 (JP); NARASAKI, Tetsuji, Komaki-shi Aichi 485-8550 (JP); KATAYAMA, Kazutaka, Komaki-shi Aichi 485-8550 (JP)
(74) Representative: Becker Kurig Straus
(86) International application number: PCT/JP2016/084965
(87) International publication number: WO 2017/154276

(57) **Abstract**

Provided are a light-transmitting laminate that, even when formed in a short period of time, satisfies the adhesiveness and light transmittance of a high refractive index thin film; and a method for producing the light-transmitting laminate. A light-transmitting laminate 10 has a metal thin film layer 16, a high refractive index thin film layer 14 that has a refractive index higher than that of the metal thin film layer 16, and a light-transmitting substrate 12 in this order. The high refractive index thin film layer 14 contains a leveling agent and a high refractive index polymer that has a functional group having at least one element selected from N, O, and S, and the content of the leveling agent is in the range of 0.20-20.32 parts by mass per 100 parts by mass of the high refractive index polymer.

## Description

### [Technical Field]

The present invention relates to a light-transmitting laminate and a method for producing a light-transmitting laminate, and specifically, to a light-transmitting laminate having an excellent heat blocking property and heat insulating property and a method for producing a light-transmitting laminate.

### [Background Art]

In order to shield sunlight, light transmittance laminate films (light-transmitting laminates) having a heat blocking property may be applied to window glasses of constructions such as buildings and houses and window glasses of vehicles such as automobiles. Forming an organic thin film as a high refractive index thin film of a light-transmitting laminate has been proposed.

### [Reference List]

### [Patent Literature]

[Patent Literature 1]
WO 2014/208745

### [Summary of Invention]

### [Technical Problem]

In order to reduce production costs, it is necessary to form a high refractive index thin film in a short time. When a nano-order high refractive index thin film is formed in a short time by coating, irregularities on a surface of the thin film become larger and light transmittance decreases. Here, for example, when a leveling agent is added, adhesiveness with a metal thin film is lowered.

An objective to be achieved by the present invention is to provide a light-transmitting laminate that satisfies light transmittance and adhesiveness of a high refractive index thin film even when a film is formed in a short time, and a method for producing the same.

### [Solution to Problem]

In order to address the above problems, a light-transmitting laminate according to the present invention includes a metal thin film layer, a high refractive index thin film layer having a refractive index higher than the metal thin film layer and a light-transmitting substrate in sequence, wherein the high refractive index thin film layer contains a leveling agent and a high refractive index polymer including a functional group containing at least one element selected from among N, O, and S, and a content of the leveling agent is within a range of 0.20 to 20.32 parts by mass with respect to 100 parts by mass of a polymer of the high refractive index thin film layer.

Preferably, the metal thin film layer is made of silver or a silver alloy. Preferably, a barrier thin film made of a metal or a metal oxide is disposed between the metal thin film layer and the high refractive index thin film layer. Preferably, the high refractive index thin film layer further contains a crosslinked polymer. Preferably, the leveling agent is made of a fluorine compound. Preferably, the light-transmitting substrate is made of a polyolefin film. Preferably, the barrier thin film is made of titanium or a titanium oxide. Preferably, the high refractive index polymer is a polymer having a triazine ring.

In addition, the method for producing a light-transmitting laminate according to the present invention is a method for producing the light-transmitting laminate, which includes a process of forming the high refractive index thin film layer on the light-transmitting substrate and a process of forming the metal thin film layer on the high refractive index thin film layer, wherein the high refractive index thin film layer is formed by applying a coating solution containing the high refractive index polymer, the leveling agent and a solvent to the light-transmitting substrate and then removing the solvent.

Preferably, the solvent contains a good solvent for the high refractive index polymer and a low boiling point solvent with a boiling point of 120 °C or lower. Preferably, the low boiling point solvent is a poor solvent for the high refractive index polymer. Preferably, a mixing ratio between the good solvent and the low boiling point solvent is a mass ratio of good solvent/low boiling point solvent=50/50 to 80/20. Preferably, the coating solution further contains a crosslinking compound, and the crosslinking compound is crosslinked in a process of forming the high refractive index thin film layer. Preferably, the crosslinking compound is crosslinked by photocrosslinking.

### [Advantageous Effects of Invention]

In the light-transmitting laminate according to the present invention, since the high refractive index thin film layer contains the high refractive index polymer and a leveling agent and a content of the leveling agent is within a specific range, light transmittance and adhesiveness of the high refractive index thin film are satisfied even when a film is formed in a short time.

When the metal thin film layer is made of silver or a silver alloy, adhesiveness with the high refractive index thin film layer made of an organic thin film is excellent. In addition, light transmittance, a sunlight shielding property, and heat ray reflectivity are excellent. When a barrier thin film made of a metal or a metal oxide is disposed between the metal thin film layer and the high refractive index thin film layer, transition of the leveling agent is reduced, and accordingly, a decrease in adhesiveness between the metal thin film layer and the high refractive index thin film layer is reduced. When the high refractive index thin film layer further contains a crosslinked polymer, transition of the leveling agent is reduced, and accordingly, a decrease in adhesiveness between the metal thin film layer and the high refractive index thin film layer is reduced. When the leveling agent is made of a fluorine compound, irregularities on the surface of the thin film can be controlled to be reduced. When the light-transmitting substrate is made of a polyolefin film, a heat insulating property is further improved. When the barrier thin film is made of titanium or a titanium oxide, it is dense and has a particularly excellent effect of reducing transition of the leveling agent. When the high refractive index polymer is a polymer having a triazine ring, the refractive index of the organic thin film increases and light transmittance of the light-transmitting laminate is excellent.

In addition, the method for producing a light-transmitting laminate according to the present invention is a method for producing the light-transmitting laminate. After a coating solution containing a high refractive index polymer, a leveling agent and a solvent is applied to the light-transmitting substrate, the solvent is removed and the high refractive index thin film layer is formed. Thus, light transmittance and adhesiveness of the high refractive index thin film are satisfied even when a film is formed in a short time.

When the solvent includes a good solvent for the high refractive index polymer and a low boiling point solvent with a boiling point of 120 °C or lower, it is possible to form a film with high thickness accuracy on the light-transmitting substrate with low heat resistance. When a mixing ratio between the good solvent and the low boiling point solvent is within a specific range, storage stability and film formability on the light-transmitting substrate with low heat resistance are excellent. When the coating solution further contains a crosslinking compound and the crosslinking compound is crosslinked in the process of forming the high refractive index thin film layer, transition of the leveling agent is reduced, and accordingly, a decrease in adhesiveness between the metal thin film layer and the high refractive index thin film layer is reduced. When the crosslinking compound is crosslinked by photocrosslinking, the coating solution can also be applied to the light-transmitting substrate with low heat resistance.

### [Brief Description of Drawings]

Fig. 1 is a cross-sectional view of a light-transmitting laminate according to a first embodiment of the present invention.
Fig. 2 is a cross-sectional view of a light-transmitting laminate according to a second embodiment of the present invention.
Fig. 3 is a cross-sectional view of a modified example of the light-transmitting laminate according to the first embodiment.
Fig. 4 is a cross-sectional view of a modified example of the light-transmitting laminate according to the second embodiment.
Fig. 5 is a cross-sectional view of a modified example of the light-transmitting laminate according to the first embodiment.

### [Description of Embodiments]

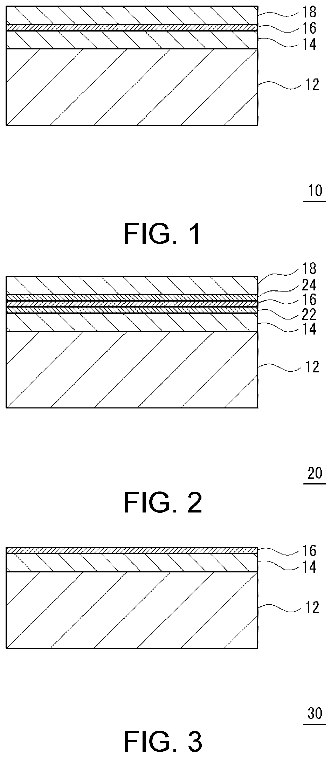

A light-transmitting laminate according to the present invention will be described in detail. Fig. 1 is a cross-sectional view of a light-transmitting laminate according to a first embodiment of the present invention.

A light-transmitting laminate 10 includes a metal thin film layer 16, a high refractive index thin film layer 14, and a light-transmitting substrate 12 in sequence. The high refractive index thin film layer 14 is provided in contact with one surface of the light-transmitting substrate 12. The metal thin film layer 16 is provided in contact with the high refractive index thin film layer 14. A high refractive index thin film layer 18 is additionally provided in contact with a surface of the metal thin film layer 16.

The light-transmitting substrate 12 is a substrate that serves as a base for forming thin film layers such as the high refractive index thin film layer 14 and the metal thin film layer 16. A material of the light-transmitting substrate 12 is not particularly limited as long as it has light transmittance, can form a thin film on its surface without problems, and has flexibility. For example, a light-transmitting polymer film and flexible glass may be exemplified. The light transmittance herein means that a value of transmittance in a wavelength range of 360 to 830 nm is 50% or more.

As a material of the light-transmitting polymer film, specifically, polymer materials such as polyethylene terephthalate, polycarbonate, polymethylmethacrylate, polyethylene, polypropylene, an ethylene-a olefin copolymer, a cycloolefin polymer, an ethylene-vinyl acetate copolymer, polystyrene, polyamide, polybutylene terephthalate, polyether ether ketone, polyvinyl chloride, polyvinylidene chloride, triacetyl cellulose, and polyurethane may be exemplified. These may be used alone or two or more thereof may be used in combination. Among them, in consideration of excellent transparency, durability, and processability, polyethylene terephthalate, polycarbonate, polymethylmethacrylate, polyethylene, polypropylene, an ethylene-a olefin copolymer, and a cycloolefin polymer may be exemplified as more preferable materials. In addition, polyolefins (chain polyolefins, cyclic polyolefins) such as polyethylene, polypropylene, an ethylene-a olefin copolymer, and a cycloolefin polymer may be exemplified as most preferable materials.

Since polyolefins do not have a functional group like polyethylene terephthalate (PET), infrared absorption of the film itself is lowered. In this case, heating heat generated inside a room is not easily absorbed and a heat insulating property is further improved. In addition, since a polyolefin film has excellent flexibility, polyolefin film is suitably applied for an application for which flexibility is required. In addition, the polyolefin film is cheaper than a PET film. The film has a thin film form and generally has a thickness of 200 µm or less or 250 µm or less. Any film may be used as long as it has sufficient flexibility to be wound into a roll form, and the film may be thick with a thickness of 200 µm or more or 250 µm or more. The film is generally supplied in the roll form.

Regarding polyolefins, in consideration of light transmittance, durability, and processability, polypropylene is preferable. In particular, in consideration of light transmittance, biaxially oriented polypropylene (OPP) is preferable. Among polyolefin films, the biaxially oriented polypropylene is preferable because it has relatively high stiffness.

A surface treatment is performed on one surface or both surfaces of the polyolefin film. Examples of the surface treatment include a corona treatment and a plasma treatment. According to the surface treatment, hydroxyl groups, oxygen groups and the like are formed on the surface of the polyolefin film, and adhesiveness with a layer that is in contact with the polyolefin film is improved.

In consideration of removability during application of the light-transmitting laminate 10, the thickness of the light-transmitting polymer film is preferably 10 µm or more, more preferably 15 µm or more, and most preferably 20 µm or more. In addition, in consideration of excellent productivity in a roll to roll method, the thickness is preferably 100 µm or less and more preferably 50 µm or less.

The metal thin film layer 16 is made of a metal that is likely to reflect far infrared rays and can function as a sunlight blocking layer. As a metal of the metal thin film layer 16, silver, a silver alloy, aluminum, an aluminum alloy, iron, and an iron alloy may be exemplified. These may be used alone or two or more thereof may be used in combination as a metal of the metal thin film layer 16. Among them, in consideration of excellent light transmittance, sunlight shielding property, and heat ray reflectivity, silver and a silver alloy are more preferable. In addition, in consideration of improvement in durability against environmental factors such as heat, light, and water vapor, a silver alloy is most preferable. As the silver alloy, a silver alloy that contains silver as a main component and contains at least one metal element such as copper, bismuth, gold, palladium, platinum, and titanium is preferable, and a silver alloy containing copper (Ag-Cu alloy), a silver alloy containing bismuth (Ag-Bi alloy), a silver alloy containing titanium (Ag-Ti alloy), and the like are more preferable.

In consideration of stability and a sunlight shielding property, the film thickness of the metal thin film layer 16 is preferably 3 nm or more, more preferably 4 nm or more, and most preferably 5 nm or more. In addition, in consideration of light transmittance and cost, the film thickness is preferably 30 nm or less, more preferably 20 nm or less, and most preferably 15 nm or less.

When the high refractive index thin film layers 14 and 18 are laminated together with the metal thin film layer 16, they can exhibit a function such as increasing light transmittance. The high refractive index thin film layers 14 and 18 have a refractive index higher than the metal thin film layer 16. The refractive index refers to a refractive index for light of 633 nm. The refractive index of the high refractive index thin film layers 14 and 18 is preferably 1.6 or more and more preferably 1.7 or more.

The high refractive index thin film layers 14 and 18 are made of an organic thin film. Inorganic thin films such as a metal oxide thin film break easily. When the high refractive index thin film layers 14 and 18 are made of an organic thin film, breaking of the high refractive index thin film layers 14 and 18 is likely to be reduced. The high refractive index thin film layers 14 and 18 contain a high refractive index polymer and a leveling agent. The high refractive index polymer may be a crosslinked polymer or an uncrosslinked polymer. Among them, in consideration of excellent processability, an uncrosslinked polymer is more preferable.

The high refractive index polymer is made of an organic polymer having a functional group containing at least one element selected from among N, S, and O. The organic polymer having such a functional group tends to have a relatively high refractive index. An organic polymer containing particularly N and S among N, S, and O is preferable because it tends to have a particularly high refractive index. In addition, these elements are elements that strongly bind with a metal in the metal thin film layer 16. Due to a functional group containing these elements, the high refractive index thin film layers 14 and 18 made of an organic thin film strongly adhere to the metal thin film layer 16 that is in contact with the high refractive index thin film layers 14 and 18 and adhesiveness with the metal thin film layer 16 becomes favorable. Among N, S, and O, particularly, N and S are elements that strongly bind to Ag among metals. An organic polymer having a functional group containing N or S has particularly favorable adhesiveness with the metal thin film layer 16 containing Ag.

As a functional group containing S, a sulfonyl group (-SO₂-), a thiol group, and a thioester group may be exemplified. Among them, in consideration of more excellent adhesiveness with the metal thin film layer 16, a sulfonyl group and a thiol group are more preferable. In addition, as a polymer having a functional group containing S, polyethersulfone (PES), polysulfone, and polyphenylsulfone may be exemplified.

As a functional group containing O, a carboxyl group, an ester group, a ketone group, and a hydroxyl group may be exemplified. Among them, in consideration of more excellent adhesiveness with the metal thin film layer 16, a carboxyl group and an ester group are more preferable. In addition, as a polymer having a functional group containing O, an epoxy resin may be exemplified.

As a functional group containing N, a carbazole group, an imide group, and a nitrile group may be exemplified. Among them, in consideration of more excellent adhesiveness with the metal thin film layer 16, a carbazole group and an imide group are more preferable. In addition, as a polymer having a functional group containing N, polyvinylcarbazole (PVK) and polyimide may be exemplified. In addition, a polymer having a triazine ring may be exemplified. The polymer having a triazine ring is particularly preferable because it has a relatively high refractive index (1.70 or more) due to its structure.

As the leveling agent, nonionic surfactants, for example, polyoxyethylene alkyl ethers such as polyoxyethylene lauryl ether, polyoxyethylene stearyl ether, polyoxyethylene cetyl ether, and polyoxyethylene oleyl ether; polyoxyethylene alkyl allyl ethers such as polyoxyethylene octylphenol ether and polyoxyethylene nonylphenol ether; polyoxyethylene and polyoxypropylene block copolymers; sorbitan fatty acid esters such as sorbitan monolaurate, sorbitan monopalmitate, sorbitan monostearate, sorbitan monooleate, sorbitan trioleate, and sorbitan tristearate; polyoxyethylenesorbitan fatty acid esters such as polyoxyethylenesorbitan monolaurate, polyoxyethylenesorbitan monopalmitate, polyoxyethylenesorbitan monostearate, polyoxyethylenesorbitan trioleate, and polyoxyethylenesorbitan tristearate, fluorine-based surfactants, for example, products named EFTOP EF301, EF303, and EF352 (commercially available from Mitsubishi Materials Electronic Chemicals Co., Ltd. (formerly Gemco)), products named Megaface F171, F173, R-08, R-30, F-553, F-554, RS-75, and RS-72-K (commercially available from DIC), Fluorad FC430 and FC431 (commercially available from Sumitomo 3M Limited), products named AsahiGuard AG710, Surflon S-382, SC101, SC102, SC103, SC104, SC105, and SC106 (commercially available from Asahi Glass Co., Ltd.), and organosiloxane polymer KP341 (commercially available from Shin-Etsu Chemical Co., Ltd.), and BYK-302, BYK-307, BYK-322, BYK-323, BYK-330, BYK-333, BYK-370, BYK-375, and BYK-378 (commercially available from BYK Japan) may be exemplified. Among them, a fluorine compound is particularly preferable. When the leveling agent is made of a fluorine compound, irregularities on the surface of the thin film can be controlled to be reduced.

A content of the leveling agent in the high refractive index thin film layers 14 and 18 is within a range of 0.20 to 20.32 parts by mass with respect to 100 parts by mass of the high refractive index polymer of the high refractive index thin film layers 14 and 18. When the content is less than 0.20 parts by mass, irregularities on the surface of the thin film become larger when a film is formed in a short time, and light transmittance of the high refractive index thin film layers 14 and 18 is not satisfied. When the content exceeds 20.32 parts by mass, adhesiveness of the metal thin film layer 16 to the high refractive index thin film layers 14 and 18 is not satisfied. In addition, when the leveling agent is added, the refractive index of the high refractive index thin film layers 14 and 18 is lowered and light transmittance is not satisfied. In consideration of reducing irregularities on the surface of the thin film when a film is formed in a short time as described above, the content is more preferably 0.5 parts by mass or more, and most preferably 1.0 part by mass or more. In addition, in consideration of adhesiveness and light transmittance described above, the content is more preferably 15 parts by mass or less, and most preferably 10 parts by mass or less.

The high refractive index thin film layers 14 and 18 may further contain a crosslinked polymer. When the high refractive index thin film layers 14 and 18 further contain a crosslinked polymer, it is possible to reduce transition of the leveling agent. Therefore, it is possible to reduce a decrease in adhesiveness of the metal thin film layer 16 to the high refractive index thin film layers 14 and 18. In addition, peeling off of the high refractive index thin film layer 14 even in a wet heat environment is reduced. The reason why the high refractive index thin film layer 14 is likely to peel off under a wet heat environment (for example, 60 °C, 90% RH) is speculated to be as follows. Since an uncrosslinked polymer swells under a wet heat environment due to a functional group and is dried in a swollen state, the uncrosslinked polymer becomes porous and the strength decreases. The crosslinked polymer is not particularly limited, and a multifunctional acrylate polymer and a multifunctional methacrylate polymer may be exemplified. Since such polymers are unlikely to generate radicals when they receive sunlight, weatherability is also improved.

A crosslinking method for a crosslinked polymer is not particularly limited, and various methods such as peroxide crosslinking, sulfur crosslinking, and photocrosslinking may be exemplified. Among them, photocrosslinking is preferable. Crosslinking can be performed at a low temperature, and it is possible to reduce thermal deformation of a substrate with low heat resistance, for example, a polyolefin film. In addition, crosslinking is possible with light in a short time. The multifunctional acrylate polymer and the multifunctional methacrylate polymer can be photocrosslinked.

The multifunctional acrylate or multifunctional methacrylate is not particularly limited as long as it includes two or more (meth)acryl groups in one molecule. Specifically, ethylene glycol diacrylate, ethylene glycol dimethacrylate, polyethylene glycol diacrylate, polyethylene glycol dimethacrylate, ethoxylated bisphenol A diacrylate, ethoxylated bisphenol A dimethacrylate, ethoxylated trimethylolpropane triacrylate, ethoxylated trimethylolpropane trimethacrylate, ethoxylated glycerin triacrylate, ethoxylated glycerin trimethacrylate, ethoxylated pentaerythritol tetraacrylate, ethoxylated pentaerythritol tetramethacrylate, ethoxylated dipentaerythritol hexaacrylate, polyglycerol monoethylene oxide polyacrylate, polyglycerol polyethylene glycol polyacrylate, dipentaerythritol hexaacrylate, dipentaerythritol hexamethacrylate, neopentyl glycol diacrylate, neopentyl glycol dimethacrylate, pentaerythritol triacrylate, pentaerythritol trimethacrylate, trimethylolpropane triacrylate, trimethylolpropane trimethacrylate, tricyclodecanedimethanol diacrylate, tricyclodecanedimethanol dimethacrylate, 1,6-hexanediol diacrylate, and 1,6-hexanediol dimethacrylate may be exemplified.

When the multifunctional acrylate or multifunctional methacrylate is used, a photo radical polymerization initiator can be used. The photo radical polymerization initiator may be appropriately selected from among known photo radical polymerization initiators and used. For example, acetophenones, benzophenones, Michler's benzoyl benzoate, amyloxime ester, tetramethylthiuram monosulfide and thioxanthones may be exemplified. When the photo radical polymerization initiator is used, it is preferably used within a range of 0.1 to 15 parts by mass, and more preferably within a range of 1 to 10 parts by mass with respect to 100 parts by mass of the multifunctional acrylate or multifunctional methacrylate.

Polymer components of the high refractive index thin film layers 14 and 18 may include other polymers, and may include the high refractive index polymer and the crosslinked polymer. In the high refractive index thin film layers 14 and 18, the content of the crosslinked polymer is preferably within a range of 2 to 100 parts by mass and more preferably within a range of 5 to 20 parts by mass with respect to 100 parts by mass of the high refractive index polymer. When the content of the crosslinked polymer is 2 parts by mass or more with respect to 100 parts by mass of the high refractive index polymer, transition of the leveling agent is likely to be reduced, and accordingly, a decrease in adhesiveness of the metal thin film layer 16 to the high refractive index thin film layers 14 and 18 is likely to be reduced. When the content of the crosslinked polymer is 100 parts by mass or less with respect to 100 parts by mass of the high refractive index polymer, since the content of the crosslinked polymer is reduced, it is possible to maintain a high refractive index. In addition, adhesive strength of the high refractive index thin film layer 14 according to the high refractive index polymer is excellent.

The high refractive index thin film layer 14 that is in contact with the light-transmitting substrate 12 may further contain a silane coupling agent, an acrylic additive, and an inorganic filler, or a combination of two or more thereof. When the high refractive index thin film layer 14 further contains a silane coupling agent, an acrylic additive, and an inorganic filler, or a combination of two or more thereof, it is possible to improve adhesiveness with the light-transmitting substrate 12. Accordingly, it is possible to secure adhesiveness high enough to reduce peeling off even in a 180° peeling test. In this case, when the silane coupling agent and the acrylic additive are used in combination, it is possible to further improve adhesiveness with the light-transmitting substrate 12.

When the silane coupling agent is added, a covalent bond with a hydroxyl group on the surface of the light-transmitting substrate 12 is formed and it is possible to improve adhesiveness with the light-transmitting substrate 12. The silane coupling agent may have a functional group other than an alkoxysilyl group or may have no other functional group. In consideration of improvement in adhesiveness with the light-transmitting substrate 12, a silane coupling agent that further has a functional group other than an alkoxysilyl group is more preferable. As the functional group other than an alkoxysilyl group, a vinyl group, an epoxy group, a styryl group, a methacryloxy group, an acryloxy group, an amino group, a ureido group, a mercapto group, a sulfide group, and an isocyanate group may be exemplified. One of these may be used alone or two or more thereof may be used in combination for the silane coupling agent. In consideration of a particularly strong effect of improving adhesiveness with the light-transmitting substrate 12, an epoxy group, a methacryloxy group, an acryloxy group, an amino group, and a ureido group are preferable among such functional groups. In addition, in consideration of particularly high coating solution stability, a methacryloxy group, an acryloxy group, and a ureido group are preferable.

As a silane coupling agent (vinyl type) having a vinyl group, vinyltrimethoxysilane and vinyltriethoxysilane may be exemplified. As a silane coupling agent (epoxy type) having an epoxy group, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, and 3-glycidoxypropyltriethoxysilane may be exemplified. As a silane coupling agent (methacrylic type) having a methacryloxy group, 3-methacryloxypropylmethyldimethoxysilane, 3-methacryloxypropyltrimethoxysilane, 3-methacryloxypropylmethyldiethoxysilane, and 3-methacryloxypropyltriethoxysilane may be exemplified. As a silane coupling agent (acrylic type) having an acryloxy group, 3-acryloxypropyltrimethoxysilane may be exemplified. As a silane coupling agent (amine type) having an amino group, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, and N-(vinylbenzyl)-2-aminoethyl-3-aminopropyltrimethoxysilane may be exemplified. As a silane coupling agent (sulfide type) having a sulfide group, bis(triethoxysilylpropyl)tetrasulfide may be exemplified.

A content of the silane coupling agent in the high refractive index thin film layer 14 is preferably within a range of 5 to 90 parts by mass, more preferably within a range of 10 to 60 parts by mass, and most preferably within a range of 20 to 40 parts by mass with respect to 100 parts by mass of the high refractive index polymer of the high refractive index thin film layer 14. When the content of the silane coupling agent is 10 parts by mass or more with respect to 100 parts by mass of the high refractive index polymer, an effect of improving adhesiveness with the light-transmitting substrate 12 is more excellent. When the content of the silane coupling agent is 20 parts by mass or more with respect to 100 parts by mass of the high refractive index polymer, an effect of improving adhesiveness with the light-transmitting substrate 12 is particularly excellent.

When the acrylic additive is added, three-dimensional crosslinking can be introduced to improve heat resistance and film strength, and to improve adhesiveness. As the acrylic additive, a multifunctional acrylate polymer and a multifunctional methacrylate polymer may be exemplified. In addition, a monofunctional acrylate polymer or a monofunctional methacrylate polymer may be used. The multifunctional acrylate polymer or the multifunctional methacrylate polymer can be appropriately selected from among those described above. The monofunctional acrylate polymer or the monofunctional methacrylate polymer can be appropriately selected from among those described below. One of those may be used alone or two or more thereof may be used in combination for the acrylic additive.

As the monofunctional acrylate polymer or the monofunctional methacrylate polymer, acrylic acid, methacrylic acid, maleic acid, fumaric acid, 2-ethylhexyl acrylate, 2-ethylhexyl methacrylate, tricyclodecanyl acrylate, isobornyl acrylate, ethyl carbitol acrylate, tetrahydrofurfuryl acrylate, lauryl acrylate, benzyl acrylate, cyclohexyl acrylate, 2-hydroxypropyl acrylate, 2-hydroxypropyl methacrylate, 2-ethylhexyl carbitol acrylate, 2-phenoxyethyl acrylate, caprolactone-modified tetrahydrofurfuryl acrylate, caprolactone-modified tetrahydrofurfuryl methacrylate, t-butylaminoethyl acrylate, and t-butylaminoethyl methacrylate may be exemplified.

A content of the acrylic additive in the high refractive index thin film layer 14 is preferably within a range of 10 to 50 parts by mass, more preferably within a range of 10 to 40 parts by mass, and most preferably within a range of 15 to 30 parts by mass with respect to 100 parts by mass of the high refractive index polymer of the high refractive index thin film layer 14. When the content of the acrylic additive is 10 parts by mass or more with respect to 100 parts by mass of the high refractive index polymer, an effect of improving adhesiveness with the light-transmitting substrate 12 is more excellent.

As the inorganic filler, zirconium dioxide, titanium dioxide, silicon dioxide, and aluminum oxide may be exemplified. Among them, zirconium dioxide, titanium dioxide, and silicon dioxide are particularly preferable in consideration of a heat transmission coefficient. These may be used alone or two or more thereof may be used in combination.

A content of the inorganic filler in the high refractive index thin film layer 14 is preferably within a range of 0.55 to 30 parts by mass, and more preferably within a range of 0.73 to 5.0 parts by mass with respect to 100 parts by mass of the high refractive index polymer of the high refractive index thin film layer 14. When the content of the inorganic filler is 0.55 parts by mass or more with respect to 100 parts by mass of the high refractive index polymer, an effect of improving adhesiveness with the light-transmitting substrate 12 is more excellent.

The film thickness of the high refractive index thin film layers 14 and 18 can be adjusted in consideration of a sunlight shielding property, visibility, and a reflection color. The film thickness of the high refractive index thin film layers 14 and 18 is preferably 5 nm or more, more preferably 8 nm or more, and most preferably 10 nm or more in order to easily reduce red or yellow coloring of reflection color and to easily obtain high light transmittance. In addition, the film thickness of the high refractive index thin film layers 14 and 18 is preferably 90 nm or less, more preferably 85 nm or less, and most preferably 80 nm or less in order to easily reduce green coloring of reflection color and to easily obtain high light transmittance.

A gel fraction of the high refractive index thin film layers 14 and 18 is preferably 20% or more and more preferably 30% or more. When the gel fraction is 20% or more, solvent resistance after the high refractive index thin film layers 14 and 18 are formed is secured. In addition, the gel fraction of the high refractive index thin film layers 14 and 18 is preferably 90% or less and more preferably 80% or less. When the gel fraction is 90% or less, cure shrinkage when the high refractive index thin film layers 14 and 18 are formed is reduced and peeling off of the high refractive index thin film layers 14 and 18 is reduced. The gel fraction of the high refractive index thin film layers 14 and 18 can be adjusted according to a combining ratio of the high refractive index polymer and the crosslinked polymer.

The light-transmitting laminate 10 can be produced by a production method according to the present invention. The production method according to the present invention includes a process of forming the high refractive index thin film layer 14 on the light-transmitting substrate 12 (first process) and a process of forming the metal thin film layer 16 on the high refractive index thin film layer 14 (second process). The metal thin film layer 16 can be formed by a sputtering method or the like. The light-transmitting laminate 10 is obtained by additionally forming the high refractive index thin film layer 18 on the metal thin film layer 16 (third process). A coating solution containing a high refractive index polymer, a leveling agent and a solvent is applied to the light-transmitting substrate 12 and the solvent is then removed so that the high refractive index thin film layers 14 and 18 are formed. The high refractive index polymer and the leveling agent are as described above.

The solvent preferably contains at least a good solvent for a high refractive index polymer, which dissolves the high refractive index polymer. As a good solvent for the high refractive index polymer, propylene glycol mono methyl ether, ethylene glycol monomethyl ether, propylene glycol, propylene glycol monoethyl ether, ethylene glycol monoethyl ether, ethylene glycol monoisopropyl ether, ethylene glycol methyl ether acetate, ethylene glycol ethyl ether acetate, propylene glycol monomethyl ether acetate, cyclohexanone, cyclopentanone, formamide, N,N-dimethylformamide, heptanol, p-xylene, m-xylene, and o-xylene may be exemplified. These may be used alone or two or more thereof may be used in combination as a good solvent for the high refractive index polymer. Among them, cyclopentanone is particularly preferable in consideration of a short-time film forming property and productivity. The solvent may include only one or two or more good solvents for the high refractive index polymer, or may include a poor solvent for the high refractive index polymer other than the good solvent for the high refractive index polymer. Many good solvents have a boiling point higher than the following low boiling point solvents.

The solvent preferably further includes a low boiling point solvent with a boiling point of 120 °C or lower in addition to the good solvent for the high refractive index polymer. When the low boiling point solvent is included, since the solvent can be removed at a relatively low temperature, it is possible to form a film with high thickness accuracy on a light-transmitting substrate with low heat resistance. The low boiling point solvent may be a good solvent for the high refractive index polymer or a poor solvent for the high refractive index polymer. As the low boiling point solvent, alcohols such as methanol, ethanol, propanol, butanol, and isopropyl alcohol, organic acid esters such as ethyl acetate, ketones such as acetonitrile, acetone, methyl ethyl ketone, and 4-methyl-2-pentanone, cycloethers such as tetrahydrofuran, and dioxane, hydrocarbons such as hexane, and aromatic compounds such as toluene may be exemplified. These may be used alone or two or more thereof may be used in combination as the low boiling point solvent. Among them, in consideration of a short-time film forming property, and productivity, methyl ethyl ketone is particularly preferable. A boiling point of the low boiling point solvent is more preferably 110 °C or lower, and most preferably 100 °C or lower. On the other hand, in consideration of a change in solid content due to volatilization, the boiling point of the low boiling point solvent is preferably 30 °C or higher and more preferably 40 °C or higher. The good solvent and the poor solvent differ in dissolution stability (precipitation).

A method of removing a solvent is not particularly limited, and a method such as evaporation by heating, natural volatilization, and distillation under reduced pressure can be used. Among them, in consideration of excellent cost, a method of evaporation by heating is preferable.

In the production method according to the present invention, in consideration of cost, continuous film formation in which the process of forming the high refractive index thin film layer 14 on the light-transmitting substrate 12 (first process) and the process of forming the metal thin film layer 16 on the high refractive index thin film layer 14 (second process) are continuously performed is preferable. Specifically, the long light-transmitting substrate 12 is unfolded from a first drum in a roll to roll method, the coating solution is applied to the light-transmitting substrate 12 on a line toward a second drum, the solvent is subsequently removed by a method such as heating and the high refractive index thin film layer 14 is formed on the light-transmitting substrate 12 (first process), the metal thin film layer 16 is subsequently formed on the high refractive index thin film layer 14 by a method such as sputtering (second process), the high refractive index thin film layer 18 is formed according to the high refractive index thin film layer 14 as necessary, and then winding on the second drum is performed for production.

When the solvent is removed by heating in the continuous film formation, in consideration of productivity and product stability, a heating time in the heating process is preferably 10 to 180 s, and more preferably 15 to 120 s. When the heating time is 10 s or longer, an evaporation rate of the solvent is reduced, irregularities on the surface of the thin film are prevented from becoming too large, and a decrease in light transmittance is likely to be reduced. In addition, in this regard, a heating time in the heating process is more preferably 15 s or longer, and most preferably 20 s or longer. In addition, when the heating time is 180 s or shorter, a short-time film forming property and productivity are excellent. In addition, in this regard, the heating time in the heating process is more preferably 120 s or shorter, and most preferably 60 s or shorter. A heating time and a heating temperature may be determined in consideration of a material of the light-transmitting substrate 12, productivity, and product stability. When a film with low heat resistance such as a polyolefin film is used as the light-transmitting substrate 12, preferably the heating time is 60 s or shorter, and the heating temperature is 90 °C or lower.

A mixing ratio between the good solvent and the low boiling point solvent is preferably a mass ratio of good solvent/low boiling point solvent=50/50 to 80/20. When a proportion of the low boiling point solvent is 50 mass% or less with respect to 100 mass% in total of the good solvent and the low boiling point solvent, dissolution stability of the high refractive index polymer in the coating solution and storage stability of the coating solution are excellent. In this regard, the proportion of the low boiling point solvent is more preferably 45 mass% or less, and most preferably 40 mass% or less. In addition, when the proportion of the low boiling point solvent is 20 mass% or more with respect to 100 mass% in total of the good solvent and the low boiling point solvent, an effect of forming a film with high thickness accuracy on the light-transmitting substrate with low heat resistance is more excellent. In this regard, the proportion of the low boiling point solvent is more preferably 25 mass% or more, and most preferably 30 mass% or more.

The coating solution may further contain a crosslinking compound in addition to the high refractive index polymer, the leveling agent and the solvent. When the coating solution further contains a crosslinking compound and the crosslinking compound is crosslinked in the process of forming the high refractive index thin film layers 14 and 18, the high refractive index thin film layers 14 and 18 contain the crosslinked polymer, transition of the leveling agent is reduced, and accordingly, a decrease in adhesiveness between the metal thin film layer 16 and the high refractive index thin film layers 14 and 18 is reduced. The crosslinking compound forming a crosslinked polymer is a crosslinkable compound (monomer, oligomer, polymer, and prepolymer). The crosslinking compound is not particularly limited, and a multifunctional acrylate and a multifunctional methacrylate may be exemplified. Since such polymers are unlikely to generate radicals when they receive sunlight, weatherability of the high refractive index thin film layers 14 and 18 is also improved. As the multifunctional acrylate and the multifunctional methacrylate, those described above may be exemplified.

A crosslinking method for a crosslinking compound is not particularly limited, and various methods such as peroxide crosslinking, sulfur crosslinking, and photocrosslinking may be exemplified. Among them, photocrosslinking is preferable. Crosslinking can be performed at a low temperature, and it is possible to reduce thermal deformation of a substrate with low heat resistance, for example, a polyolefin film. In addition, crosslinking is possible with light in a short time. The multifunctional acrylate and the multifunctional methacrylate can be photocrosslinked.

According to the light-transmitting laminate 10 having the above configuration, the high refractive index thin film layers 14 and 18 contain the high refractive index polymer and the leveling agent and a content of the leveling agent is within a specific range. Therefore, light transmittance and adhesiveness of the high refractive index thin film are satisfied even when a film is formed in a short time. When the high refractive index thin film layers 14 and 18 further contain a crosslinked polymer, transition of the leveling agent is reduced, and accordingly, a decrease in adhesiveness between the metal thin film layer 16 and the high refractive index thin film layers 14 and 18 is reduced.

The leveling agent exhibits an effect of improving wettability by lowering surface tension of the coating solution and irregularities on the surface of the thin film are reduced after the solvent is removed. However, when the leveling agent is made of a fluorine compound, the leveling agent is unevenly distributed in the vicinity of the surface of the coated solution, an evaporation rate of the solvent is controlled, and thus irregularities on the surface of the thin film after the solvent is removed can be controlled to be reduced. Accordingly, it is possible to secure excellent light transmittance even when a nano-order level film is formed in a short time.

Thus, in a method for producing a light-transmitting laminate according to the present invention, after a coating solution containing a high refractive index polymer, a leveling agent and a solvent is applied to the light-transmitting substrate, the solvent is removed and the high refractive index thin film layer is formed. Thus, light transmittance and adhesiveness of the high refractive index thin film are satisfied even when a film is formed in a short time. When the solvent includes a good solvent for the high refractive index polymer and a low boiling point solvent with a boiling point of 120 °C or lower, it is possible to form a film with high thickness accuracy on the light-transmitting substrate with low heat resistance. When a mixing ratio between the good solvent and the low boiling point solvent is within a specific range, storage stability and film formability on the light-transmitting substrate with low heat resistance are excellent. When the coating solution further contains a crosslinking compound and the crosslinking compound is crosslinked in the process of forming the high refractive index thin film layer, transition of the leveling agent is reduced, and accordingly, a decrease in adhesiveness between the metal thin film layer and the high refractive index thin film layer is reduced. When the crosslinking compound is crosslinked by photocrosslinking, the coating solution can also be applied to the light-transmitting substrate with low heat resistance.

Next, a light-transmitting laminate according to a second embodiment of the present invention will be described. Fig. 2 is a cross-sectional view of the light-transmitting laminate according to the second embodiment of the present invention.

A light-transmitting laminate 20 includes the metal thin film layer 16, the high refractive index thin film layer 14, and the light-transmitting substrate 12 in sequence. On both surfaces of the metal thin film layer 16, barrier thin films 22 and 24 are provided in contact with the metal thin film layer 16. That is, the barrier thin film 22 is disposed between the metal thin film layer 16 and the high refractive index thin film layer 14, and the barrier thin film 24 is disposed between the metal thin film layer 16 and the high refractive index thin film layer 18. The high refractive index thin film layer 14 is provided in contact with one surface of the light-transmitting substrate 12. The barrier thin film 22 is provided in contact with the high refractive index thin film layer 14. The metal thin film layer 16 is provided in contact with the barrier thin film 22. The barrier thin film 24 is provided in contact with the metal thin film layer 16. The high refractive index thin film layer 18 is additionally provided in contact with the surface of the barrier thin film 24.

Comparing the light-transmitting laminate 10 according to the first embodiment, the light-transmitting laminate 20 according to the second embodiment is the same as the light-transmitting laminate 10 according to the first embodiment except that the barrier thin films 22 and 24 are provided on both surfaces of the metal thin film layer 16. Like reference numerals denote like elements, and descriptions thereof will be omitted.

The barrier thin films 22 and 24 are made of a metal or a metal oxide. Due to the barrier thin films 22 and 24, transition of the leveling agent is reduced, and accordingly, a decrease in adhesiveness between the metal thin film layer 16 and the high refractive index thin film layers 14 and 18 is reduced.

In the barrier thin films 22 and 24, types of a metal and a metal oxide are not particularly limited. As the metal, titanium, zinc, indium, tin, magnesium, zirconium, niobium, cerium, nickel, chromium, tungsten, molybdenum, and silicon may be exemplified. As the metal oxide, a titanium oxide, zinc oxide, indium oxide, a tin oxide, an indium-tin oxide, magnesium oxide, aluminum oxide, zirconium oxide, a niobium oxide, a cerium oxide, a nickel oxide, a chromium oxide, a tungsten oxide, a molybdenum oxide, and silica may be exemplified. Among them, titanium or a titanium oxide is preferable. Since the barrier thin films 22 and 24 made of titanium or a titanium oxide are dense, an effect of reducing transition of the leveling agent is particularly excellent.

The barrier thin films 22 and 24 are layers that may be provided in order to reduce transition of the leveling agent. However, when the thickness thereof is too thick, since light transmittance is lowered, the thickness is preferably thin (thin film) in consideration of light transmittance. For example, in conversion of a film formation rate, a range of 0.3 to 5.0 nm is preferable and a range of 0.5 to 3.0 nm is more preferable.

The barrier thin films 22 and 24 are preferably formed by a vapor deposition method in order to form dense films and to uniformly form a thin film of about several nm to several tens of nm. As the vapor deposition method, physical vapor deposition (PVD) such as a vacuum deposition method, a sputtering method, an ion plating method, an MBE method, and a laser ablation method and chemical vapor deposition (CVD) such as a thermal CVD method and a plasma CVD method may be exemplified. Among them, a sputtering method such as a DC magnetron sputtering method and an RF magnetron sputtering method is preferable in order to easily control a film thickness.

According to the light-transmitting laminate 20 having the above configuration, as in the light-transmitting laminate 10, the high refractive index thin film layers 14 and 18 contain the high refractive index polymer and the leveling agent, and a content of the leveling agent is within a specific range. Therefore, light transmittance and adhesiveness of the high refractive index thin film are satisfied even when a film is formed in a short time. In addition, since the barrier thin film 22 is disposed between the metal thin film layer 16 and the high refractive index thin film layer 14, transition of the leveling agent is reduced, and accordingly, a decrease in adhesiveness between the metal thin film layer 16 and the high refractive index thin film layer 14 is reduced. In addition, since the barrier thin film 24 is disposed between the metal thin film layer 16 and the high refractive index thin film layer 18, transition of the leveling agent is reduced, and accordingly, a decrease in adhesiveness between the metal thin film layer 16 and the high refractive index thin film layer 18 is reduced.

While embodiments of the present invention have been described above, the present invention is not limited to the embodiments, and various modifications can be made without departing from the spirit and scope of the present invention.

For example, while the high refractive index thin film layer 18 is provided in contact with a surface of the metal thin film layer 16 in the first embodiment, like a light-transmitting laminate 30 shown in Fig. 3, a configuration in which no high refractive index thin film layer 18 is provided on a surface of the metal thin film layer 16 may be used. In addition, also in the light-transmitting laminate 20 according to the second embodiment, like the light-transmitting laminate 30 shown in Fig. 3, a configuration in which no high refractive index thin film layer 18 is provided may be used.

In addition, for example, in the first embodiment and the second embodiment, a 3-layer structure in which the metal thin film layer 16 is one layer and the high refractive index thin film layers 14 and 18 are disposed on both surfaces thereof is shown. However, a lamination structure of the metal thin film layer and the high refractive index thin film layer is not limited thereto. Two or more layers in total may be laminated, for example, metal thin film layer/high refractive index thin film layer/metal thin film layer/high refractive index thin film layer ···in order from the side of the light-transmitting substrate 12 or two or more layers in total may be laminated, for example, high refractive index thin film layer/metal thin film layer/high refractive index thin film layer/metal thin film layer/high refractive index thin film layer ··· in order from the side of the light-transmitting substrate 12.

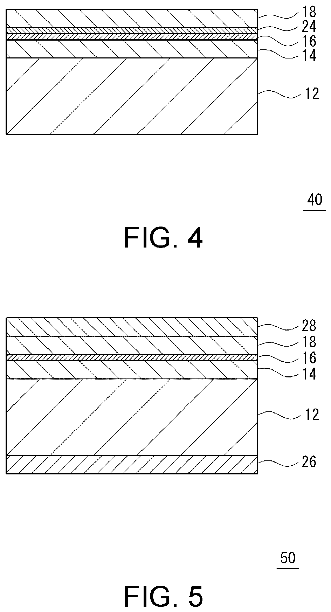

In addition, for example, in the second embodiment, the barrier thin films 22 and 24 are provided on both surfaces of the metal thin film layer 16. However, as shown in Fig. 4, a configuration in which the barrier thin film 24 is provided on one surface (a surface on the side of the high refractive index thin film layer 18) of the metal thin film layer 16, and no barrier thin film 22 is provided on a surface of the metal thin film layer 16 on the side of the high refractive index thin film layer 14 may be used.

In addition, for example, in the first embodiment and the second embodiment, an adhesive layer may be provided on a surface of the high refractive index thin film layer 18. The adhesive layer is a layer for bonding a light-transmitting laminate to an adherend such as a window and a display, and includes an attaching agent or an adhesive. A surface of the adhesive layer is covered with a separator as necessary. In addition, for example, in the first embodiment and the second embodiment, a surface protective layer may be provided on the other surface of the light-transmitting substrate 12. The surface protective layer is a layer that is disposed as the outmost layer and scratching on the surface of the light-transmitting substrate is prevented. Fig. 5 shows a light-transmitting laminate 50 in which, with respect to the light-transmitting laminate 10 according to the first embodiment, additionally, an adhesive layer 28 is provided on a surface of the high refractive index thin film layer 18 and a surface protective layer 26 is provided on a surface of the light-transmitting substrate 12.

The surface protective layer can be made of a curable resin such as an acrylic resin or an organic-inorganic hybrid material. The organic-inorganic hybrid material is a material that contains an organic component such as a curable resin and an inorganic component such as inorganic particles and an organic metal compound. In consideration of an excellent heat insulating property (a heat transmission coefficient is controlled to be smaller), the thickness of the surface protective layer is preferably 2.5 µm or less, more preferably 2.0 µm or less, and most preferably 1.5 µm or less. In addition, in consideration of excellent scratch resistance, the thickness is preferably 0.4 µm or more, more preferably 0.6 µm or more, and most preferably 0.8 µm or more.

The light-transmitting laminate according to the present invention can be appropriately used as a light transmittance laminate film having a heat blocking property for window glasses of constructions such as buildings and houses and window glasses of vehicles such as automobiles in order to shield sunlight.

### Examples

The present invention will be described below in detail with reference to examples and comparative examples.

### (Examples 1 to 4)

As light-transmitting laminates according to Examples 1 to 4, on one surface of a light-transmitting substrate made of a polyolefin film, a high refractive index thin film layer made of an organic thin film, a metal thin film layer and a high refractive index thin film layer made of an organic thin film were laminated in that order to produce the light-transmitting laminate (Fig. 1). Details are as follows.

### <Preparing coating solution for organic thin film>

A coating solution for an organic thin film with a viscosity (0.1 to 3.0 mPa·s) that can be applied using a gravure coater was prepared according to formulations shown in Table 1.
- UR-108NPT3: commercially available from Nissan Chemical Industries, Ltd. (polymer having a triazine ring, photopolymerization initiator, a component containing a multifunctional acrylate), solid concentration 3 mass%, solvent: cyclopentanone
- Leveling agent ("Megaface F-559" commercially available from DIC Corporation, fluorine compound (oligomer))
- Good solvent for polymer having a triazine ring: cyclopentanone
- Low boiling point solvent: methyl ethyl ketone, 4-methyl-2-pentanone

### <Producing light-transmitting laminate>

A corona treatment was performed on both surfaces of an OPP film ("Torafan BO 40-2500" commercially available from Shin-Etsu Chemical Co., Ltd., thickness: 40 µm). The coating solution for an organic thin film was applied to one surface thereof using a micro gravure coater, dried at 80 °C for 60 seconds, ultraviolet rays were then emitted at 200 mJ/cm² and a crosslinking treatment was performed, and thereby an organic thin film (film thickness 20 nm) was formed. Next, a Ag-Cu alloy thin film (film thickness 7.8 nm) was formed on a first layer organic thin film by sputtering. Next, a second layer organic thin film (film thickness 20 nm) was formed on the Ag-Cu alloy thin film in the same manner as in the first layer organic thin film. Thereby, light-transmitting laminates of Examples 1 to 4 were produced.

### (Example 5)

As a light-transmitting laminate according to Example 5, on one surface of a light-transmitting substrate made of a polyolefin film, a high refractive index thin film layer made of an organic thin film, a barrier thin film made of a metal, a metal thin film layer, a barrier thin film made of a metal, and a high refractive index thin film layer made of an organic thin film were laminated in sequence to produce the light-transmitting laminate (Fig. 2). Details are as follows.

### <Producing light-transmitting laminate>

A corona treatment was performed on both surfaces of an OPP film ("Torafan BO 40-2500" commercially available from Shin-Etsu Chemical Co., Ltd., thickness: 40 µm). The coating solution for an organic thin film was applied to one surface thereof using a micro gravure coater, dried at 80 °C for 60 seconds, ultraviolet rays were then emitted at 200 mJ/cm² and a crosslinking treatment was performed, and thereby an organic thin film (film thickness 20 nm) was formed. Next, a first layer titanium thin film (film thickness 2 nm) was formed on the first layer organic thin film by sputtering. Next, a Ag-Cu alloy thin film (film thickness 7.8 nm) was formed on the first layer titanium thin film by sputtering. Next, a second layer titanium thin film (film thickness 2 nm) was formed on the Ag-Cu alloy thin film by sputtering. Next, in the same manner as in the first layer organic thin film, a second layer organic thin film (film thickness 20 nm) was formed on the titanium thin film. Thereby, a light-transmitting laminate of Example 5 was produced.

### (Example 6)

The light-transmitting laminate produced in Example 5 was heated in a heating furnace at 40 °C for 300 hours, and the first layer and second layer titanium thin films were oxidized to prepare a titanium oxide thin film. Thereby, a light-transmitting laminate of Example 6 was produced.

### (Example 7)

A light-transmitting laminate of Example 7 was produced in the same manner as in Example 5 except that a process of forming a first layer titanium thin film in Example 5 was omitted and a Ag-Cu alloy thin film was formed on the first layer organic thin film. As the light-transmitting laminate of Example 7, on one surface of a light-transmitting substrate made of a polyolefin film, a high refractive index thin film layer made of an organic thin film, a metal thin film layer, a barrier thin film made of titanium, and a high refractive index thin film layer made of an organic thin film were laminated in sequence to produce the light-transmitting laminate (Fig. 4).

### (Example 8)

The light-transmitting laminate produced in Example 7 was heated in a heating furnace at 40 °C for 300 hours, and the titanium thin film was oxidized to prepare a titanium oxide thin film. Thereby, a light-transmitting laminate of Example 8 was produced.

### (Example 9)

A light-transmitting laminate of Example 9 was produced in the same manner as in Example 3 except that, when a coating solution for an organic thin film was prepared, UR-108NT3 was used in place of UR-108NPT3, and no crosslinking treatment was performed on the organic thin film.
- UR-108NT3: commercially available from Nissan Chemical Industries, Ltd. (polymer having a triazine ring, a component containing a photopolymerization initiator), solid concentration 3 mass%, solvent: cyclohexanone

### (Example 10)

As a light-transmitting laminate according to Example 10, on one surface of a light-transmitting substrate made of a polyolefin film, a high refractive index thin film layer made of an organic thin film and a metal thin film layer were laminated in sequence to produce a light-transmitting laminate (Fig. 3).

That is, a light-transmitting laminate of Example 10 was produced in the same manner as in Example 3 except that no second layer organic thin film was formed.

### (Example 11)

Both first layer and second layer organic thin films were formed using a coating solution for an organic thin film with the same composition as in Example 2. A layer structure was the same as in Example 6. Thereby, a light-transmitting laminate was produced.

### (Examples 12 to 27)

A second layer organic thin film was formed using a coating solution for an organic thin film with the same composition as in Example 2. A first layer organic thin film that was in contact with a light-transmitting substrate was formed by mixing a silane coupling agent and an acrylic additive into a coating solution for an organic thin film with the same composition as in Example 2 according to the formulation shown in Table 4. A layer structure was the same as in Example 6. Thereby, light-transmitting laminates were produced.
- Silane coupling agent (amine type): "KBM-903" commercially available from Shin-Etsu Chemical Co., Ltd.
- Silane coupling agent (acrylic type): "KBM-5103" commercially available from Shin-Etsu Chemical Co., Ltd.
- Acrylic additive: "Z-729-35" commercially available from Aica Kogyo Company, Limited

### (Comparative Examples 1 and 2)

A light-transmitting laminate of Comparative Example 1 was produced in the same manner as in Example 1 except that, when a coating solution for an organic thin film was prepared, no leveling agent was added. In addition, a light-transmitting laminate of Comparative Example 2 was produced in the same manner as in Example 1 except that a leveling agent was added in an amount shown in Table 1.

### (Measurement of Cu content)

A content of a sub-element (Cu) in the Ag-Cu alloy thin film layer was as follows. That is, separately, a test piece in which a Ag-Cu alloy thin film layer was formed on a glass substrate was produced under each film formation condition. The test piece was immersed in a 6% HNO₃ solution and eluted by ultrasonic waves for 20 minutes. Then, measurement was performed by a concentration method of an ICP analysis technique using the obtained sample solution. A Cu content was 4 atom%.

### (Measurement of film thickness of thin film)

The film thickness of each thin film was measured from cross-section observation of the test piece using the field emission electron microscope (HRTEM) ("JEM2001F" commercially available from JEOL Ltd.,).

Light transmittance and adhesiveness of the light-transmitting laminates were evaluated. In addition, a heat insulating property and a heat blocking property were also evaluated. In addition, regarding Examples 11 to 27, adhesiveness according to a 180° peeling test was evaluated.

### (Light transmittance)

A test piece 1 was produced by bonding a plate glass with a thickness of 3 mm and a functional film surface side of a light-transmitting laminate (hereinafter referred to as a film) with an acrylic adhesive sheet ("5402" commercially available from Sekisui Chemical Co., Ltd.) with a thickness of 25 µm. Using the test piece 1, a transmission spectrum of a wavelength of 380 nm to 780 nm was measured by a spectrophotometer (commercially available from Shimadzu Corporation) according to JIS A5759, and thus visible light transmittance was obtained. An external appearance was visually confirmed from a position away from 30 cm while reflecting light of a three-wavelength fluorescent lamp to a film. When the visible light transmittance was 60% or more and an external appearance had no color unevenness, the transparency (light transmittance) was determined as good "○." When the visible light transmittance was less than 60% or an external appearance had a color unevenness, the transparency (light transmittance) was determined as poor "×."

### (Adhesiveness: grid peeling)

Measurement was performed according to JIS K5600-5-6. A blade was placed so that it was perpendicular to a surface of an OPP film on which a functional film was formed, 6 notches were made at intervals of 2 mm, and a 90° direction was then changed and 6 notches perpendicular to the preceding notch were made at intervals of 2 mm, and thereby 25 squares were produced. Then, a tape was bonded to a part cut into a lattice of the film and the tape was rubbed. Then, the tape was reliably peeled off at an angle of about 60 degrees, and the number of remaining squares was visually checked. When the number of remaining squares was 25, the adhesiveness was determined as very good "⊚." When the number of remaining squares was 20 or more and less than 25, the adhesiveness was determined as good "○." When the number of remaining squares was less than 20, adhesiveness was determined as poor "×."

### (Adhesiveness: 180° peeling)

By a 180° peeling method according to JIS-A-5759, a peeling test was performed between a light-transmitting substrate and a high refractive index thin film layer. Under conditions of a sample width of 25 mm and a tensile speed of 300 mm/min, when no peeling occurred, it was determined as very good "⊚." When peeling occurred but an amount thereof was small, it was determined as good "○." When peeling occurred and an amount thereof was large, it was determined as Slightly poor "Δ."

### (Heat insulating property)

Using the test piece 1, a reflection spectrum with a wavelength of 5 µm to 50 µm was measured by an infrared spectroscopic analyzer (commercially available from Shimadzu Corporation) according to JIS R3106 to obtain a vertical emissivity, corrected emissivities on the glass surface side and film surface side corrected with a coefficient described in JIS A5759 were obtained, and a heat transmission coefficient (W/(m²·K)) was obtained by a calculation method in JIS A5759. When the heat transmission coefficient was 5.0 W/(m²·K) or less, the heat insulating property was determined as good "○." When the heat transmission coefficient was greater than 5.0 W/(m²·K), the heat insulating property was determined as poor " ×."

### (Heat blocking property)

Using the test piece 1, a transmission spectrum and a reflection spectrum with a wavelength of 300 nm to 2500 nm were measured by a spectrophotometer (commercially available from Shimadzu Corporation) according to JIS A5759, a sunlight transmittance and a sunlight reflectance were obtained, a reflection spectrum with a wavelength of 5 µm to 50 µm was measured by an infrared spectroscopic analyzer (commercially available from Shimadzu Corporation) according to JIS R3106 to obtain a vertical emissivity, corrected emissivities on the glass surface side and film surface side corrected with a coefficient described in JIS A5759, and a shielding coefficient was obtained by a calculation method in JIS A5759. When the shielding coefficient was 0.69 or less, the heat blocking property was determined as good "○." When the shielding coefficient was greater than 0.69, the heat blocking property was determined as poor " ×."

**[Table 1]**

| Materials | Boiling point (°C) | Exam ples | | | | | | | | | | Comparative Examples | |
|---|---|---|---|---|---|---|---|---|---|---|---|---|---|
| | | 1 | 2 | 3 | 4 | 5 | 6 | 7 | 8 | 9 | 10 | 1 | 2 |
| UR-108NPT3 | - | 100 | 100 | 100 | 100 | 100 | 100 | 100 | 100 | - | 100 | 100 | 100 |
| UR-108NT3 | - | - | - | - | - | - | - | - | - | 100 | - | - | - |
| Leveling agent | - | 0.005 | 0.010 | 0.15 | 0.50 | 0.15 | 0.15 | 0.15 | 0.15 | 0.15 | 0.15 | 0 | 0.88 |
| Cyclopentane | 130 | 88.2 | 88.2 | 88.2 | 88.2 | 88.2 | 88.2 | 88.2 | 88.2 | 88.2 | 88.2 | 88.2 | 88.2 |
| Pure water | 100 | 7.9 | 7.9 | 7.9 | 7.9 | 7.9 | 7.9 | 7.9 | 7.9 | 7.9 | 7.9 | 7.9 | 7.9 |
| Methyl ethyl ketone | 79 | 74.3 | 74.3 | 74.3 | 74.3 | 74.3 | 74.3 | 74.3 | 74.3 | 74.3 | 74.3 | 74.3 | 74.3 |
| 4-Methyl-2-pentanone | 116 | 29.7 | 29.7 | 29.7 | 29.7 | 29.7 | 29.7 | 29.7 | 29.7 | 29.7 | 29.7 | 29.7 | 29.7 |

**[Table 2]**

| | | Examples | | | | Comparative Examples | |
|---|---|---|---|---|---|---|---|
| | | 1 | 2 | 3 | 4 | 1 | 2 |
| Light-transmitting substrate | Material | OPP | OPP | OPP | OPP | OPP | OPP |
| High refractive index thin film layer (first layer) | Material | Triazine+acrylate | Triazine+acrylate | Triazine+acrylate | Triazine+acrylate | Triazine+acrylate | Triazine+acrylate |
| | Crosslinked /uncrosslinked | Crosslinked | Crosslinked | Crosslinked | Crosslinked | Crosslinked | Crosslinked |
| Barrier thin film | Material | - | - | - | - | - | - |
| Metal thin film layer | Material | Ag-Cu | Ag-Cu | Ag-Cu | Ag-Cu | Ag-Cu | Ag-Cu |
| Barrier thin film | Material | - | - | - | - | - | - |
| High refractive index thin film layer (second layer) | Material | Triazine+acrylate | Triazine+acrylate | Triazine+acrylate | Triazine+acrylate | Triazine+acrylate | Triazine+acrylate |
| | Crosslinked /uncrosslinked | Crosslinked | Crosslinked | Crosslinked | Crosslinked | Crosslinked | Crosslinked |
| Content of leveling agent (parts by mass) | | 0.20 | 0.41 | 6.10 | 20.32 | 0 | 35.77 |
| Light transmittance (transparency) | | ○ | ○ | ○ | ○ | × | × |
| Adhesiveness | | ○ | ○ | ○ | ○ | ○ | × |
| Heat insulating property | | ○ | ○ | ○ | ○ | ○ | ○ |
| Heat blocking property | | ○ | ○ | ○ | ○ | ○ | ○ |

| | | | | | | | |
|---|---|---|---|---|---|---|---|
| Contents of the first layer and second layer leveling agents are amounts with respect to 100 parts by mass of the polymer having a triazine ring. The polymer having a triazine ring refers to a polymer having a triazine ring included in "UR-108NPT3." | | | | | | | |

**[Table 3]**

| | | Examples | | | | | |
|---|---|---|---|---|---|---|---|
| | | 5 | 6 | 7 | 8 | 9 | 10 |
| Light-transmitting substrate | Material | OPP | OPP | OPP | OPP | OPP | OPP |
| High refractive index thin film layer (first layer) | Material | Triazine+acrylate | Triazine+acrylate | Triazine+acrylate | Triazine+acrylate | Triazine | Triazine+acrylate |
| | Crosslinked /uncrosslinked | Crosslinked | Crosslinked | Crosslinked | Crosslinked | Uncrosslinked | Crosslinked |
| Barrier thin film | Material | Titanium | Titanium oxide | - | - | - | - |
| Metal thin film layer | Material | Ag-Cu | Ag-Cu | Ag-Cu | Ag-Cu | Ag-Cu | Ag-Cu |
| Barrier thin film | Material | Titanium | Titanium oxide | Titanium | Titanium oxide | - | - |
| High refractive index thin film layer (second layer) | Material | Triazine+acrylate | Triazine+acrylate | Triazine+acrylate | Triazine+acrylate | Triazine | - |
| | Crosslinked /uncrosslinked | Crosslinked | Crosslinked | Crosslinked | Crosslinked | Uncrosslinked | - |
| Content of leveling agent (parts by mass) | | 6.10 | 6.10 | 6.10 | 6.10 | 6.10 | 6.10 |
| Light transmittance (transparency) | | ○ | ○ | ○ | ○ | ○ | ○ |
| Adhesiveness | | ⊚ | ⊚ | ⊚ | ⊚ | ○ | ○ |
| Heat insulating property | | ○ | ○ | ○ | ○ | ○ | ○ |
| Heat blocking property | | ○ | ○ | ○ | ○ | ○ | ○ |

| | | | | | | | |
|---|---|---|---|---|---|---|---|
| Contents of the first layer and second layer leveling agents are amounts with respect to 100 parts by mass of the polymer having a triazine ring. The polymer having a triazine ring refers to a polymer having a triazine ring included in "UR-108NPT3" or "UR-108NT3." | | | | | | | |

**[Table 4]**

| Materials | Boiling point (°C) | Examples | | | | | | | | | | | | | | | | |
|---|---|---|---|---|---|---|---|---|---|---|---|---|---|---|---|---|---|---|
| | | 11 | 12 | 13 | 14 | 15 | 16 | 17 | 18 | 19 | 20 | 21 | 22 | 23 | 24 | 25 | 26 | 27 |
| UR-108NPT3 | - | 100 | 100 | 100 | 100 | 100 | 100 | 100 | 100 | 100 | 100 | 100 | 100 | 100 | 100 | 100 | 100 | 100 |
| Leveling agent | | 0.010 | 0.010 | 0.010 | 0.010 | 0.010 | 0.010 | 0.010 | 0.010 | 0.010 | 0.010 | 0.010 | 0.010 | 0.010 | 0.010 | 0.010 | 0.010 | 0.010 |
| Silane coupling agent (amine type) | | - | 0.15 | 0.45 | 0.90 | 1.80 | 2.70 | - | - | - | - | - | - | 0.02 | - | - | - | - |
| Silane coupling agent (acrylic type) | | - | - | - | - | - | - | 0.15 | 0.45 | 0.90 | - | - | - | - | 0.02 | 0.30 | 0.45 | 0.75 |
| Acrylic additive | | - | - | - | - | - | - | - | - | - | 0.78 | 1.04 | 1.55 | 1.55 | 1.55 | 1.55 | 1.55 | 1.55 |
| Cyclopentanone | 130 | 88.2 | 88.2 | 88.2 | 88.2 | 88.2 | 88.2 | 88.2 | 88.2 | 88.2 | 88.2 | 88.2 | 88.2 | 88.2 | 88.2 | 88.2 | 88.2 | 88.2 |
| Pure water | 100 | 7.9 | 7.9 | 7.9 | 7.9 | 7.9 | 7.9 | 7.9 | 7.9 | 7.9 | 7.9 | 7.9 | 7.9 | 7.9 | 7.9 | 7.9 | 7.9 | 7.9 |
| Methyl ethyl ketone | 79 | 74.3 | 74.3 | 74.3 | 74.3 | 74.3 | 74.3 | 74.3 | 74.3 | 74.3 | 74.3 | 74.3 | 74.3 | 74.3 | 74.3 | 74.3 | 74.3 | 74.3 |
| 4-Methyl-2-pentanone | 116 | 29.7 | 29.7 | 29.7 | 29.7 | 29.7 | 29.7 | 29.7 | 29.7 | 29.7 | 29.7 | 29.7 | 29.7 | 29.7 | 29.7 | 29.7 | 29.7 | 29.7 |

**[Table 5]**

| | | Examples | | | | | | | | | | | | | | | | |
|---|---|---|---|---|---|---|---|---|---|---|---|---|---|---|---|---|---|---|
| | | 11 | 12 | 13 | 14 | 15 | 16 | 17 | 18 | 19 | 20 | 21 | 22 | 23 | 24 | 25 | 26 | 27 |
| Light-transmitting substrate | Material | OPP | | | | | | | | | | | | | | | | |
| High refractive index thin film layer (first layer) | Material | Triazine+acrylate | | | | | | | | | | | | | | | | |
| | Crosslinked/uncrosslinked | Crosslinked | | | | | | | | | | | | | | | | |
| Barrier thin film | Material | Titanium oxide | | | | | | | | | | | | | | | | |
| Metal thin film layer | Material | Ag-Cu | | | | | | | | | | | | | | | | |
| Barrier thin film | Material | Titanium oxide | | | | | | | | | | | | | | | | |
| High refractive index thin film layer (second layer) | Material | Triazine+acrylate | | | | | | | | | | | | | | | | |
| | Crosslinked/uncrosslinked | Crosslinked | | | | | | | | | | | | | | | | |
| Content of leveling agent (parts by mass) | | 0.41 | 0.41 | 0.41 | 0.41 | 0.41 | 0.41 | 0.41 | 0.41 | 0.41 | 0.41 | 0.41 | 0.41 | 0.41 | 0.41 | 0.41 | 0.41 | 0.41 |
| Silane coupling agent: amine type (parts by mass) | | - | 5.0 | 15.0 | 30.0 | 60.0 | 90.0 | - | - | - | - | - | - | 0.6 | - | - | - | - |
| Silane coupling agent: acrylic type (parts by mass) | | - | - | - | - | - | - | 5.0 | 15.0 | 30.0 | - | - | - | - | 0.6 | 10.0 | 15.0 | 25.0 |
| Acrylic additive (parts by mass) | | - | - | - | - | - | - | - | - | - | 15.0 | 20.0 | 30.0 | 30.0 | 30.0 | 30.0 | 30.0 | 30.0 |
| Light transmittance (transparency) | | ○ | ○ | ○ | ○ | ○ | ○ | ○ | ○ | ○ | ○ | ○ | ○ | ○ | ○ | ○ | ○ | ○ |
| Adhesiveness | Grid peeling | ⊚ | ⊚ | ⊚ | ⊚ | ⊚ | ⊚ | ⊚ | ⊚ | ⊚ | ⊚ | ⊚ | ⊚ | ⊚ | ⊚ | ⊚ | ⊚ | ⊚ |
| | 180° peeling | Δ | Δ | ○ | ⊚ | ⊚ | ⊚ | Δ | ○ | ○ | ○ | ⊚ | ⊚ | ⊚ | ○ | ⊚ | ⊚ | ⊚ |
| Heat insulating property | | ○ | ○ | ○ | ○ | ○ | ○ | ○ | ○ | ○ | ○ | ○ | ○ | ○ | ○ | ○ | ○ | ○ |
| Heat blocking property | | ○ | ○ | ○ | ○ | ○ | ○ | ○ | ○ | ○ | ○ | ○ | ○ | ○ | ○ | ○ | ○ | ○ |

| | | | | | | | | | | | | | | | | | | |
|---|---|---|---|---|---|---|---|---|---|---|---|---|---|---|---|---|---|---|
| Contents of the first layer and second layer leveling agents are amounts with respect to 100 parts by mass of the polymer having a triazine ring. The polymer having a triazine ring refers to a polymer having a triazine ring included in "UR-108NPT3" or "UR-108NT3." Contents of the first layer silane coupling agent and the acrylic additive are amounts with respect to 100 parts by mass of the polymer having a triazine ring. | | | | | | | | | | | | | | | | | | |

In Comparative Example 1, no leveling agent was contained in the coating solution for forming the high refractive index thin film layer, and no leveling agent was contained in the high refractive index thin film layer. Therefore, the light transmittance was poor. In Comparative Example 2, an amount of the leveling agent contained in the coating solution for forming the high refractive index thin film layer was large. Therefore, the light transmittance and the adhesiveness were poor. On the other hand, in examples, a specific amount of the leveling agent was contained in the coating solution for forming the high refractive index thin film layer, and a specific amount of the leveling agent was contained in the high refractive index thin film layer. Therefore, the light transmittance and the adhesiveness were excellent even in film formation in a short time.

In addition, comparing examples, it is understood that the adhesiveness was improved when the barrier thin film was included (Examples 5 to 8). In addition, when the organic thin film was uncrosslinked, durability deteriorated under a wet heat environment. That is, when the organic thin film was crosslinked, durability was improved under a wet heat environment.

In addition, comparing examples, when either or both of the silane coupling agent and the acrylic additive were included in the coating solution for an organic thin film for forming the high refractive index thin film layer (first layer) that was in contact with the light-transmitting substrate (Examples 12 to 27), it was confirmed that the adhesiveness was improved in the peeling test according to a 180° peeling method.

While the examples of the present invention have been described above, the present invention is not limited to the examples, and various modifications can be made without departing from the spirit and scope of the present invention.

## Claims

1. A light-transmitting laminate, **characterized in that** comprising:
a metal thin film layer;
a high refractive index thin film layer having a refractive index higher than the metal thin film layer; and
a light-transmitting substrate,
wherein the high refractive index thin film layer contains a leveling agent and a high refractive index polymer comprising a functional group containing at least one element selected from among N, O, and S, and a content of the leveling agent is within a range of 0.20 to 20.32 parts by mass with respect to 100 parts by mass of a polymer of the high refractive index thin film layer.

2. The light-transmitting laminate according to claim 1, wherein the metal thin film layer is made of silver or a silver alloy.

3. The light-transmitting laminate according to claim 1 or 2, further comprising a barrier thin film made of a metal or a metal oxide disposed between the metal thin film layer and the high refractive index thin film layer.

4. The light-transmitting laminate according to any one of claims 1 to 3, wherein the high refractive index thin film layer further contains a crosslinked polymer.

5. The light-transmitting laminate according to any one of claims 1 to 4, wherein the leveling agent is made of a fluorine compound.

6. The light-transmitting laminate according to any one of claims 1 to 5, wherein the light-transmitting substrate is made of a polyolefin film.

7. The light-transmitting laminate according to claim 3, wherein the barrier thin film is made of titanium or a titanium oxide.

8. The light-transmitting laminate according to any one of claims 1 to 7, wherein the high refractive index polymer is a polymer having a triazine ring.

9. A method for producing a light-transmitting laminate, producing the light-transmitting laminate according to any one of claims 1 to 8, **characterized in that** comprising:
a process of forming the high refractive index thin film layer; and
a process of forming the metal thin film layer,
wherein the high refractive index thin film layer is formed by applying a coating solution containing the high refractive index polymer, the leveling agent and a solvent and then removing the solvent.

10. The method for producing the light-transmitting laminate according to claim 9, wherein the solvent contains a good solvent for the high refractive index polymer and a low boiling point solvent with a boiling point of 120 °C or lower.

11. The method for producing the light-transmitting laminate according to claim 10, wherein the low boiling point solvent is a poor solvent for the high refractive index polymer.

12. The method for producing the light-transmitting laminate according to claim 10 or 11, wherein a mixing ratio between the good solvent and the low boiling point solvent is a mass ratio of good solvent/low boiling point solvent=50/50 to 80/20.

13. The method for producing the light-transmitting laminate according to any one of claims 9 to 12, wherein the coating solution further contains a crosslinking compound, and the crosslinking compound is crosslinked in the process of forming the high refractive index thin film layer.

14. The method for producing the light-transmitting laminate according to claim 13, wherein the crosslinking compound is crosslinked by photocrosslinking.
